# EUROPEAN PATENT APPLICATION

(11) **EP 4 386 870 A1**
(43) Date of publication of application: **19.06.2024**
(21) Application number: 23172115.0
(22) Date of filing: 08.05.2023
(51) Int. Cl.: H01L 31/048

(54) **PHOTOVOLTAIC MODULE**

(30) Priority: 12.12.2022 CN 202211600794
(71) Applicant: Zhejiang Jinko Solar Co., Ltd., Haining, Zhejiang 314416 (CN); JINKO SOLAR CO., LTD, ShangRao, Jiangxi 334100 (CN)
(72) Inventor: GUO, Zhiqiu, Haining (CN); WU, Yuhao, Haining (CN); HAO, Guohui, Haining (CN); HUANG, Shiliang, Haining (CN)
(74) Representative: Balder IP Law, S.L.

(57) **Abstract**

The embodiments of the present application relates to the photovoltaic field and provides a photovoltaic module, which includes: a solar cell sheet, where a surface of the solar cell sheet is provided with multiple grid line structures spaced along a first direction; multiple connecting portions spaced along a second direction, where each of the multiple connecting portions is arranged on the surface of the solar cell sheet and is in electrical contact with at least one of the multiple grid line structures; each of the multiple connecting portions includes a body portion, a first portion and a second portion disposed on a surface of the body portion, the first portion is located on the surface of the solar cell sheet and is alloyed with the at least one of the multiple grid line structures, and an outer profile of the second portion away from the body portion has the same shape with an inner profile of the second portion. For the same connecting portion, an area proportion of the first portion is less than an area proportion of the second portion in a cross section perpendicular to an extension direction of the connecting portion. The photovoltaic module further includes a encapsulation layer configured to cover a surface of the connecting portion and the surface of the solar cell sheet, and a cover plate disposed on a side of the at least one encapsulation layer away from the solar cell sheet. The photovoltaic module provided by the embodiments of the present application is at least conducive to improving the connection performance between the welding strip and the solar cell sheet, and improving the yield of the solar cell sheet.

## Description

### TECHNICAL FIELD

Embodiments of the present application relate to the field of photovoltaics, and in particular to a photovoltaic module.

### BACKGROUND

A solar cell is a device that directly converts light energy into electric energy through photoelectric effect or photochemical effect. A single solar cell is impossible to generate electricity directly, several single solar cells are generally connected in series and in parallel by welding strips and tightly sealed into a solar cell module to generate electricity. The solar cell module (i.e., solar cell panel) is a core part of a solar power generation system, and also the most important part of the solar power generation system. The solar cell module is configured to convert solar energy into electric energy, or send the electric energy to an accumulator for storage, or drive load to work.

A solar cell sheet is very fragile. Generally, it is necessary to set adhesive film and cover plate on an upper surface and a lower surface of the solar cell module to protect the solar cell sheet. The at least one cover plate is generally photovoltaic glass. The photovoltaic glass cannot be directly attached to the solar cell sheet, and the adhesive film is required to play a bonding role between the photovoltaic glass and the solar cell sheet. Solder strips configured to collect current are generally used to connect a solar cell sheet to another solar cell sheet. The conventional solder strip is welded to be alloyed with a finger during welding, and is more common to include a tin soldering layer. The composition of the tin soldering layer is 60% tin and 40% lead. In the phase diagram, the eutectic temperature of the tin-lead alloy is approximately 183 °C, that is, the melting point of the tin soldering layer in the solder strip is 183 °C, while in the actual welding process, the welding temperature shall be 20 °C higher than the melting point of the solder. Due to the large warpage and deformation during the welding process, the risk of hidden crack after welding is high and the fragment rate is high. Especially for a passive emitter and rear cell (PERC), its internal stress is relatively large, and it is more prone to warpage, deformation and fragments after welding, resulting in higher component repair rate and lower yield. Under the above background, in order to improve the welding quality, low temperature welding strip is produced due to operation. However, there are many factors that affect the yield of a module, such as welding and the contact resistance between the welding strip and the finger.

### SUMMARY

Embodiments of the present application provide a photovoltaic module, which is at least conducive to improving the connection performance between a welding strip and a solar cell sheet, and improving the yield of the solar cell sheet.

According to some embodiments of the present application, a photovoltaic module is provided, and the photovoltaic module includes: a solar cell sheet, where a surface of the solar cell sheet is provided with multiple grid line structures spaced along a first direction;
multiple connecting portions spaced along a second direction, where each of the multiple connecting portions is arranged on the surface of the solar cell sheet and is in electrical contact with at least one of the multiple grid line structures; each of the multiple connecting portions includes a body portion, a first portion and a second portion disposed on a surface of the body portion, the first portion is located on the surface of the solar cell sheet and is alloyed with the at least one of the multiple grid line structures, and an outer profile of the second portion away from the body portion has the same shape with an inner profile of the second portion; for the same connecting portion, an area proportion of the first portion is less than an area proportion of the second portion in a cross section perpendicular to an extension direction of the connecting portion;
at least encapsulation layer configured to cover a surface of the plurality of connecting portions and the surface of the solar cell sheet;
at least one cover plate disposed on a side of the at least one encapsulation layer away from the solar cell sheet.

In some embodiments, the area proportion of the first portion ranges from 1/4 to 2/3 times of the area proportion of the second portion in the cross-section perpendicular to the extension direction of the connecting portion.

In some embodiments, the first direction intersects with the second direction, and the first portion is at least partially located in an overlap between the at least one of the multiple grid line structures and the body portion.

In some embodiments, an orthographic projection of the overlap between the at least one of the multiple grid line structures and the body portion on the solar cell sheet is located in an orthographic projection of the first portion on the solar cell sheet.

In some embodiments, the first direction is parallel to the second direction, and each of the multiple connecting portions is in a one-to-one correspondence each of the multiple grid line structures.

In some embodiments, the first portion is wider than each of the multiple grid line structures along the first direction.

In some embodiments, the second portion is configured to cover a surface of the body portion away from the first portion and the solar cell sheet.

In some embodiments, material of the first portion is the same as material of the second portion.

In some embodiments, the second portion has greater conductivity than the body portion.

In some embodiments, at least one of the first portion and the second portion is a layer made of tin (Sn), and the body portion is a conductive layer.

In some embodiments, the photovoltaic module further includes: multiple connecting layers spaced along the extension direction of the connecting portion, and each of the multiple connecting layers is located between the solar cell sheet and each of the multiple connecting portions.

The technical solutions provided according to the embodiments of the present application have at least the following advantages.

In the photovoltaic module provided according to the embodiments of the present application, a surface of the solar cell sheet is provided with multiple grid line structures spaced along a first direction, each of the multiple connecting portions is in electrical contact with at least one of the multiple grid line structures, and each of the multiple connecting portions includes a body portion, a first portion and a second portion disposed on a surface of the body portion. For the same connecting portion, an area proportion of the first portion is less than an area proportion of the second portion in a cross-section perpendicular to an extension direction of the connecting portion. It can be naturally deduced that the connection between the connecting portion and the solar cell sheet is not achieved by heating a top portion of the connecting portion in a direction towards the solar cell sheet, which can avoid the damage, crack and excessive thermal stress of the solar cell sheet caused by the good ohmic contact between the connecting portion and the solar cell sheet. The outer profile of the second portion away from the body portion has the same shape with an inner profile of the second portion, and the second portion is not on the surface of the solar cell sheet, so that the connecting portion and the grid line structure can be alloyed by low temperature lamination. A part of the second portion is not melted, and the part of the second portion can be used as a barrier layer with enough thickness configured to prevent the body portion from piercing the at least one encapsulation layer. Each of the at least one encapsulation layer outside the multiple connecting portions can be set thinner to achieve low weight of adhesive film and reduce cost. In addition, in response to the second portion being not melt, an area of the multiple connecting portions shielding the solar cell sheet also decreases accordingly. On the one hand, the thickness of the second portion is thinner than that of the first portion at an initial stage of setting the connecting portion, which will reduce the cost. On the other hand, area of the multiple connecting portions shielding the solar cell sheet is small, which reduces the optical loss of the solar cell sheet and is conducive to improving the cell efficiency.

### BRIEF DESCRIPTION OF THE DRAWINGS

One or more embodiments are described as examples with reference to the corresponding figures in the accompanying drawings, and the exemplary description does not constitute a limitation to the embodiments. The figures in the accompanying drawings do not constitute a proportion limitation unless otherwise stated.
FIG. 1 is a first top view of a photovoltaic module provided according to an embodiment of the present application;
FIG. 2 is a schematic structural view of a cross section of the photovoltaic module shown in FIG. 1 along A1-A2;
FIG. 3 is a schematic structural view of a cross section of the photovoltaic module shown in FIG. 1 along B 1-B2;
FIG. 4 is a second top view of a photovoltaic module provided according to an embodiment of the present application;
FIG. 5 is a schematic structural view of a cross section of the photovoltaic module shown in FIG. 4 along B1-B2;
FIG. 6 is a third top view of a photovoltaic module provided according to an embodiment of the present application;
FIG. 7 is a schematic structural view of a cross section of the photovoltaic module shown in FIG. 6 along C1-C2;
FIG. 8 is a fourth top view of a photovoltaic module provided according to an embodiment of the present application;
FIG. 9 is a schematic structural view of a cross section of the photovoltaic module shown in FIG. 8 along B1-B2;
FIG. 10 is a schematic structural view of a cross section of the photovoltaic module shown in FIG. 8 along D 1-D2;
FIG. 11 is a schematic structural view of a first cross section of a connecting portion located on a grid line structure provided according to an embodiment of the present application;
FIG. 12 is a schematic structural view of a first longitudinal section of a connecting portion provided according to an embodiment of the present application;
FIG. 13 is a schematic structural view of a second longitudinal section of a connecting portion provided according to an embodiment of the present application;
FIG. 14 is a schematic structural view of a second cross section of a connecting portion located on a grid line structure provided according to an embodiment of the present application;
FIG. 15 is a schematic structural view of a third cross section of a connecting portion located on a grid line structure provided according to an embodiment of the present application;
FIG. 16 is a schematic structural view of an isolation layer provided according to an embodiment of the present application;
FIG. 17 is a schematic structural view of a cover plate provided according to an embodiment of the present application; and
FIG. 18 is a schematic structural view of a photovoltaic module after lamination provided according to an embodiment of the present application.

### DETAILED DESCRIPTION

It can be seen from the background technology that the connection performance between the welding strip and the solar cell sheet and the yield of the solar cell sheet in the photovoltaic module of the relevant technology are not desirable.

The analysis found that one of the reasons for the poor connection performance between the welding strip and the solar cell sheet in the photovoltaic module and low yield of the solar cell sheet is that solar lights enter a solar cell from a front surface of the solar cell, and a metal electrode on the front surface will block a part of the silicon sheet, and this part of the light energy on the metal electrode cannot be converted into electric energy. From this point of view, the finer the grid line is, the better. The responsibility of the grid line lies in conducting currents, from the perspective of resistivity, the finer the grid line is, the smaller the conductive cross-sectional area is, and the greater the resistance loss is. Therefore, the core of the design of the main gate and the secondary gate is to balance the shielding and conductivity, and the welding strip that is in electrical contact with the grid line also needs to balance the shielding and conductivity. In addition, in general, a temperature 20 °C higher than the melting temperature of the welding strip is used to realize the alloying of the welding strip and the grid line to radiate and release the heat from the top of the welding strip towards the solar cell sheet, so that a higher melting temperature of the welding strip requires a higher reflow temperature during the welding, which makes the solar cell sheet prone to thermal warping. The thermal warping of the solar cell sheet damages the integrity of the solder joint formed, thus affecting its performance, and a variety of solder defects, such as solar cell sheet damage, pillow effect and faulty soldering, is caused by the thermal warping.

A photovoltaic module is provided according to the embodiments of the present application, where a surface of the solar cell sheet is provided with multiple grid line structures spaced along a first direction, each of the multiple connecting portions is in electrical contact with at least one of the multiple grid line structures, and each of the multiple connecting portions includes a body portion, a first portion and a second portion disposed on a surface of the body portion. For the same connecting portion, an area proportion of the first portion is less than an area proportion of the second portion in a cross-section perpendicular to an extension direction of the connecting portion. It can be naturally deduced that the connection between the connecting portion and the solar cell sheet is not achieved by heating a top portion of the connecting portion in a direction towards the solar cell sheet, which can avoid the damage, crack and excessive thermal stress of the solar cell sheet caused by the good ohmic contact between the connecting portion and the solar cell sheet. The second portion is not on the surface of the solar cell sheet, so that the connecting portion and the grid line structure can be alloyed by low temperature lamination, the second portion is not melted. A part of the second portion is not melted, and the part of the second portion can be used as a barrier layer with enough thickness configured to prevent the body portion from piercing the at least one encapsulation layer. Each of the at least one encapsulation layer outside the multiple connecting portions can be set thinner to achieve low weight of adhesive film and reduce cost. In addition, in response to the second portion being not melt, an area of the multiple connecting portions shielding the solar cell sheet also decreases accordingly. On the one hand, the thickness of the second portion is thinner than that of the first portion at an initial stage of setting the connecting portion, which will reduce the cost. On the other hand, area of the multiple connecting portions shielding the solar cell sheet is small, which reduces the optical loss of the solar cell sheet and is conducive to improving the cell efficiency.

The embodiments of the present application will be described in detail below with reference to the accompanying drawings. However, those of ordinary skill in the art shall understand that, in each embodiment of the present application, many technical details are provided for readers to better understand the present application. However, the technical solutions claimed in the present application can be realized even without these technical details and various changes and modifications based on the following embodiments.

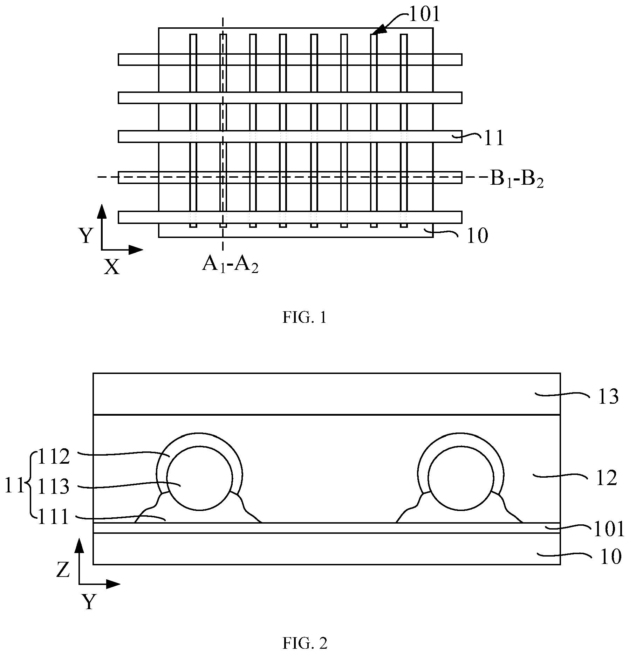

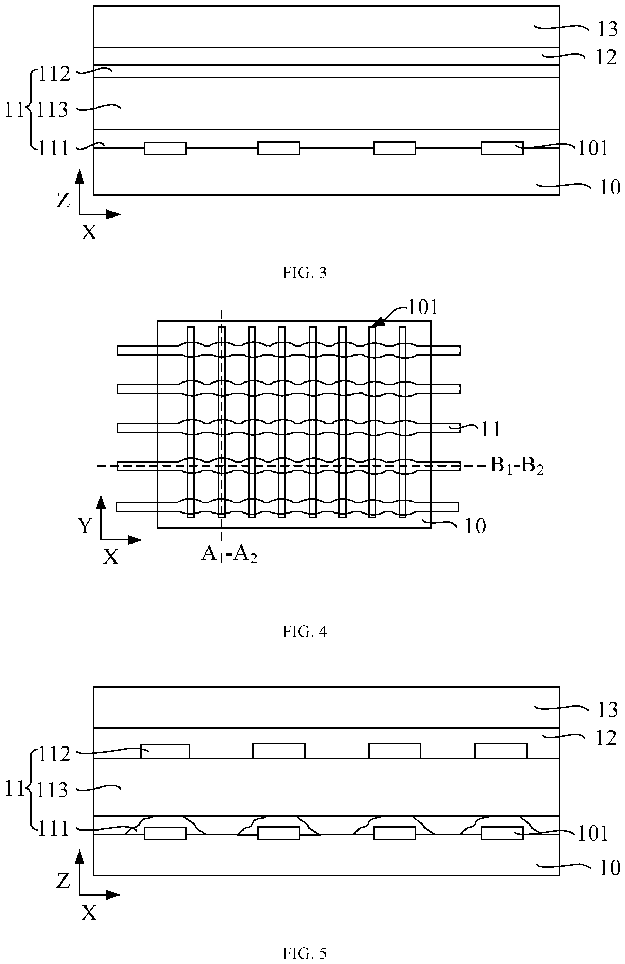

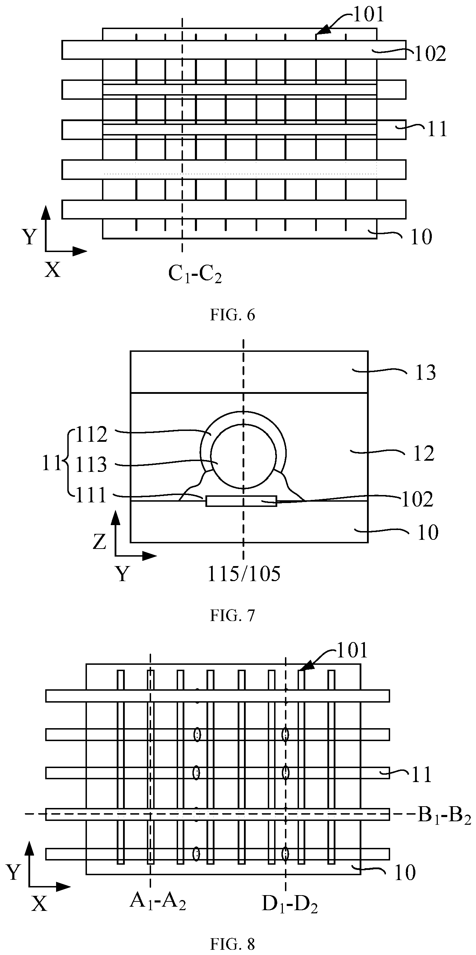

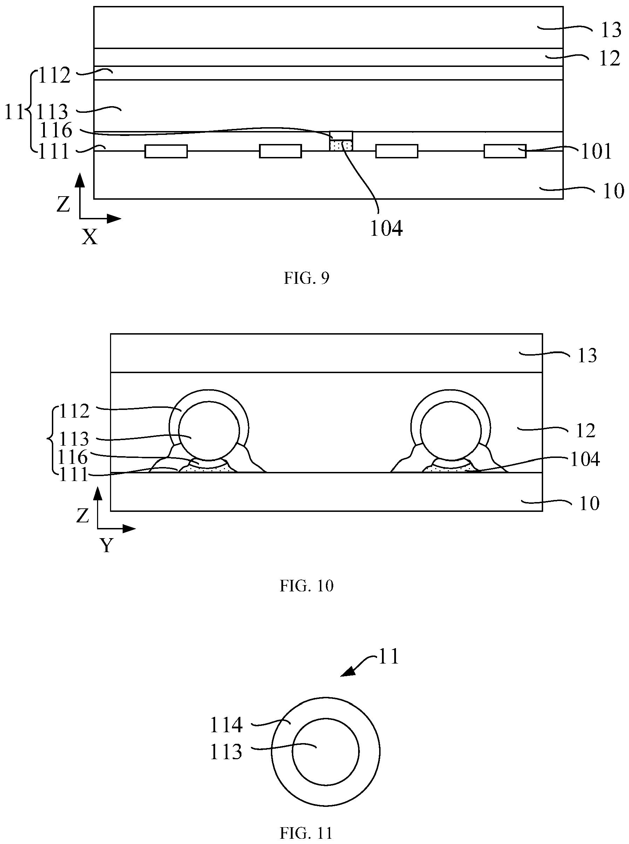

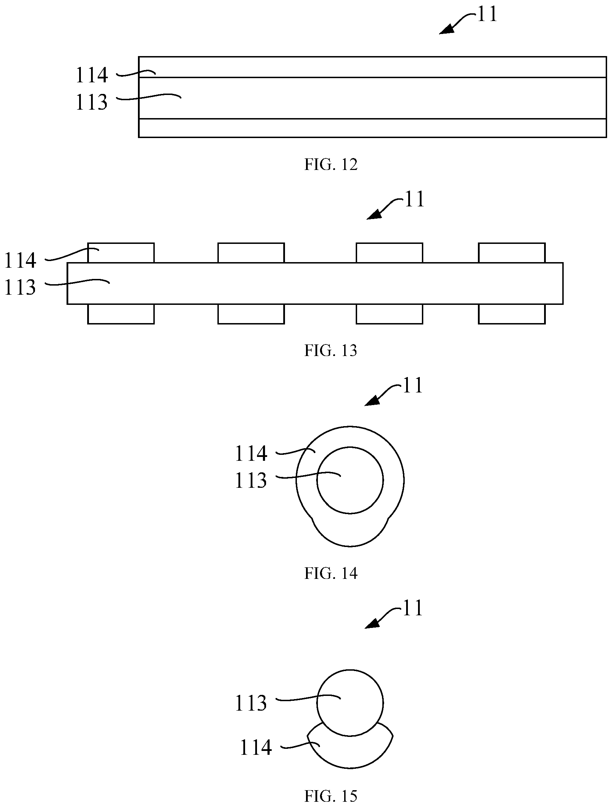

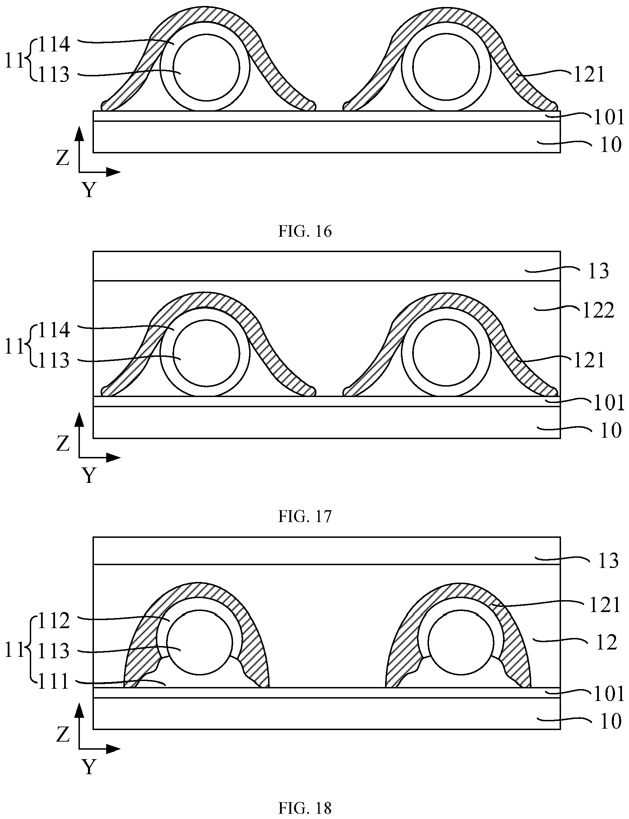

FIG. 1 is a first top view of a photovoltaic module provided according to an embodiment of the present application; FIG. 2 is a schematic structural view of a cross section of the photovoltaic module shown in FIG. 1 along A1-A2; FIG. 3 is a schematic structural view of a cross section of the photovoltaic module shown in FIG. 1 along B1-B2; FIG. 4 is a second top view of a photovoltaic module provided according to an embodiment of the present application; FIG. 5 is a schematic structural view of a cross section of the photovoltaic module shown in FIG. 4 along B1-B2; FIG. 6 is a third top view of a photovoltaic module provided according to an embodiment of the present application; FIG. 7 is a schematic structural view of a cross section of the photovoltaic module shown in FIG. 6 along C1-C2; FIG. 8 is a fourth top view of a photovoltaic module provided according to an embodiment of the present application; FIG. 9 is a schematic structural view of a cross section of the photovoltaic module shown in FIG. 8 along B1-B2; FIG. 10 is a schematic structural view of a cross section of the photovoltaic module shown in FIG. 8 along D1-D2; FIG. 11 is a schematic structural view of a first cross section of a connecting portion located on a grid line structure provided according to an embodiment of the present application; FIG. 12 is a schematic structural view of a first longitudinal section of a connecting portion provided according to an embodiment of the present application; FIG. 13 is a schematic structural view of a second longitudinal section of a connecting portion provided according to an embodiment of the present application; FIG. 14 is a schematic structural view of a second cross section of a connecting portion located on a grid line structure provided according to an embodiment of the present application; FIG. 15 is a schematic structural view of a third cross section of a connecting portion located on a grid line structure provided according to an embodiment of the present application; FIG. 16 is a schematic structural view of an isolation layer provided according to an embodiment of the present application; FIG. 17 is a schematic structural view of a cover plate provided according to an embodiment of the present application; and FIG. 18 is a schematic structural view of a photovoltaic module after lamination provided according to an embodiment of the present application.

In the top views shown in FIG. 1, FIG. 4, FIG. 6 and FIG. 8, the at least one encapsulation layer and the at least one cover plate are not shown, or the at least one encapsulation layer and the at least one cover plate are in perspective state to show and explain the position and connection relationship between the solar cell sheet and the multiple connecting portions. The cross-sectional views shown in FIG. 2, FIG. 3, FIG. 5, FIG. 7, FIG. 9, FIG. 10, and FIG. 16 to FIG. 18 only show film structures on one side of the solar cell sheet, and film structures on the other side of the solar cell sheet can be the same or different from those on the corresponding side of the solar cell sheet. FIG. 1 to FIG. 10 and FIG. 18 are schematic structural views of a photovoltaic module formed after lamination, and FIG. 16 and FIG. 17 are schematic structural views of connecting portions and grid line structures without lamination.

Referring to FIG. 1 to FIG. 15, a photovoltaic module is provided according to some embodiments of the present application, the photovoltaic module includes a solar cell sheet 10, where a surface of the solar cell sheet 10 is provided with multiple grid line structures spaced along a first direction X. The photovoltaic module further includes multiple connecting portions 11 spaced along a second direction Y, where each of the multiple connecting portions 11 is arranged on the surface of the solar cell sheet 10 and is in electrical contact with at least one of the multiple grid line structures. Each of the multiple connecting portions 11 includes a body portion 113, a first portion 111 and a second portion 112 disposed on a surface of the body portion 113. The first portion 111 is located on the surface of the solar cell sheet 10 and is alloyed with the at least one of the multiple grid line structures, and an outer profile of the second portion 112 away from the body portion 113 has the same shape with an inner profile of the second portion 112. For the same connecting portion 11, an area proportion of the first portion 111 is less than an area proportion of the second portion 112 in a cross section perpendicular to an extension direction of the connecting portion 11. The photovoltaic module further includes a encapsulation layer 12 configured to cover a surface of the connecting portion 11 and the surface of the solar cell sheet 10, and a cover plate 13 disposed on a side of the at least one encapsulation layer 12 away from the solar cell sheet 10.

In some embodiments, the solar cell sheet 10 may be a monocrystalline silicon solar cell, a polycrystalline silicon solar cell, an amorphous silicon solar cell or a multicomponent compound solar cell. The multicomponent compound solar cell may specifically be embodied as a cadmium sulfide solar cell, a gallium arsenide solar cell, a copper indium selenium solar cell or a perovskite solar cell. In some embodiments, the solar cell sheet 10 includes but is not limited to any one of a PERC, a passivated emitter and rear totally-diffused (PERT) cell, a tunnel oxide passivated contact (TOPcon) cell, a Heterojunction with intrinsic thin layer (HIT/HJT) cell. The front side of the solar cell sheet 10 is provided with a first electrode, and a rear side opposite the front side is provided with a second electrode. The first electrode and the second electrode have different polarity, so that the film structures on one side of the solar cell sheet 10 in the cross-sectional view shown in the figures is the same as that on the other side of the solar cell sheet 10.

In some embodiments, the solar cell sheet 10 is an interdigitated back contact (IBC) crystalline silicon solar cell. The IBC cell refers to a solar cell structure with positive and negative metal electrodes arranged in a interdigitated manner on the backlight surface of the solar cell sheet. PN junction and electrodes are located at the rear surface of the IBC solar cell sheet, that is, the electrodes in the emitter and substrate areas of the IBC cell both are both at the rear surface, and the front surface of the IBC cell is not shielded by grid lines, which improves the photoelectric conversion performance of the IBC cell. The film structures on one side of the solar cell sheet 10 in the cross-sectional view shown in the figures are different from those on the other side of the solar cell sheet 10. The film structures of the solar cell sheet 10 include the at least one encapsulation layer 12 and the at least one cover plate 13.

The solar cell sheet 10 is a whole solar cell sheet or a sliced solar cell sheet. The sliced solar cell sheet refers to a solar cell sheet formed by cutting process of a complete whole solar cell sheet. The cutting process includes: liner spectral clustering (LSC) process and thermal stress cell separation (TMC) process. In some embodiments, the sliced solar cell sheet is a half solar cell sheet, and the half solar cell sheet can also be understood as a half cell or a 1/2 solar cell sheet. In some embodiments, the slice cell can be a 1/3 solar cell sheet, a 1/4 solar cell sheet, or a 1/8 solar cell sheet. The photovoltaic module composed of 1/2 solar cell sheets can improve the power generation by reducing the resistance loss. According to Ohm's law, the interconnection power loss of solar cells is proportional to the square of the current. After the solar cell sheet is cut in half, the current is also reduced by half, and the electrical loss is also reduced to a quarter of the full-size solar cell sheet loss. The increase of the number of solar cell sheets will also increase the number of solar cell sheet gaps. Through the reflection of a backplane of the photovoltaic module, the solar cell sheet gaps is conducive to improving the short-circuit current. In addition, cutting the half-cell module can optimize the width of the welding strip is optimized in the photovoltaic module composed of 1/2 solar cell sheets. Generally, it is necessary to increase the width of the welding strip to reduce the electrical loss and reduce the width of the welding strip to reduce the shielding loss. The solar cell sheet loss is reduced in the photovoltaic module composed of 1/2 solar cell sheets, and the width of the welding strip can be set to be smaller to reduce the shielding loss, which is conducive to improving the cell efficiency and power consumption.

In some embodiments, the photovoltaic module includes at least two solar cell sheets 10, and two adjacent solar cell sheets 10 are connected in series or in parallel by connecting portions to form a cell string group. There is a solar cell sheet gap between the solar cell sheets 10 to achieve electrical insulation between different solar cell sheets 10.

In some embodiments, each of the multiple grid line structures is configured to collect photogenerated current inside the solar cell and lead it to the outside of the solar cell sheet 10. The multiple grid line structures include busbars 102 and fingers 101, where the finger 101 may also be referred to as an auxiliary busbar, the finger 101 is configured to guide the current, and the busbar 102 is configured to collect and gather the current of the finger 101. In some embodiments, the grid line structures only include fingers 101, so as to shorten the carrier transport path and reduce the series resistance, thereby increasing the front light-receiving area and improving the module power, so as to increase the short-circuit current and reduce the use of the grid line printing silver paste to reduce the production cost.

In some embodiments, the connecting portion 11 is a welding strip, which is used for the interconnection between the solar cell sheets 10, and current is collected and transmitted to the elements outside the photovoltaic module. The welding strips include bus welding strips and interconnection welding strips. Each of the bus welding strips is configured to connect cell strings and junction box in the photovoltaic module, and each of the interconnection welding strips is configured to connect the solar cell sheets 10 together.

In some embodiments, referring to FIG. 11 to FIG. 15, which shows the initial state of the connecting portion 11 without welding or lamination treatment. The connecting portion 11 includes a body portion 113 and a coating layer 114 covering the surface of the body portion 113. The coating layer 114 is configured to subsequently form the first portion 111 and the second portion 112. The body portion 113 is a conductive layer. Specifically, the body portion 113 is a conductive layer with a certain strength and good conductivity. The conductive layer acts as the main conductive transmission layer of the connecting portion 11. Therefore, the lower the resistivity of the body portion 113, the smaller the electrical loss of the connecting portion 11, and the better the cell efficiency and power generation. The coating layer 114 may be plated on the surface of the body portion 113 or coated on the surface of the body portion 113. Specifically, coating material of the coating layer 114 is evenly coated around the body portion 113 according to a certain composition ratio and thickness by using special processes such as electroplating, vacuum deposition, spraying or hot dip coating. The main function of the coating layer 114 is to make the connecting portion 11 meet the weldability, and firmly weld the connecting portion 11 on the grid line structures of the solar cell sheet 10 to play a good role in current diversion.

In some embodiments, the coating layer 114 can be uniformly covered on the surface of the body portion 113 as shown in FIG. 12, or covered on the surface of the body portion 113 according to spacing arrangement of the fingers 101 and the shape feature. The width of the coating layer 114 along the extension direction of the connecting portion is greater than or equal to the width of the finger 101, and a gap between two adjacent coating layer 114 is less than a gap between two adjacent fingers 101.

In some embodiments, as shown in FIG. 14 or FIG. 15, the coating layer 114 is not uniformly coated on the surface of the body portion 113. A part of the coating layer 114 with a thicker circumference will be the first portion 111 after subsequent process, and the other part of the coating layer 114 with a thinner circumference will be the second portion 112 after subsequent process. Referring to FIG. 15, the coating layer 114 is only applied to part of the circumference of the body portion 113 for the subsequent formation of the first portion 111, that is, the coating is not applied to the area for the formation of the second portion 112. The longitudinal cross-sectional view of the connecting portion 111 shown in FIG. 14 and FIG. 15 can be as shown in FIG. 12. The coating layer 114 covers all surfaces of the body portion 113 along the extension direction of the connecting portion 11, or the coating layer 114 is arranged at intervals as shown in FIG. 13. The longitudinal cross section refers to the section along the central perpendicular line of the extension direction of the connecting portion 11, and the cross section refers to the section along the central perpendicular line of the extension direction of the connecting portion 11.

In some embodiments, material of the body portion 113 includes copper, nickel, gold, silver and other conductive materials with good conductivity, or alloy materials with low resistivity. In response to the resistivity of the body portion 113 being less than 1×10⁻⁷Ω·m, or the conductivity being greater than or equal to 1×10⁷S/m, the electrical loss of the body portion 113 is small, and the cell efficiency and power generation are large. Resistivity is a physical quantity used to represent the resistance characteristics of various substances, and to reflect the properties of substances' resistance to current. Conductivity is a parameter used to describe the difficulty of charge flow in substances. In some embodiments, the body portion 113 includes a copper layer, and the resistivity of the copper layer is low (1.75×10⁻⁸Ω·m), and the cost is lower than that of gold layer and silver layer. In addition, copper has high chemical stability and moderate strength, which will not deform during lamination treatment during welding and packaging, so that the shielding area of connecting portion 11 is small.

In some embodiments, the material of the coating layer 114 is a metal material or alloy material with a lower melting point than the body portion 113, such as tin alloy, which may include tin-zinc alloy, tin-bismuth alloy or tin-indium alloy. Tin as welding material has low melting point, good affinity with copper and other metals, and good welding fastness. The lead in the tin-lead alloy can reduce the melting point of the solder strip. The tin and lead can form a eutectic point with a melting point of 183°C, and have good weldability and usability. In the embodiments disclosed in the present application, the melting point and surface tension is reduced by replacing lead with other metal elements or adding other elements to the tin-lead alloy, such as bismuth. The melting point of Sn-Bi alloy can be reduced to 139°C to meet the requirements of low-temperature welding.

In some embodiments, the coating layer 114 is provided with flux, which refers to the chemical substances that can help and promote the welding process, and also have protective effect and prevent oxidation reaction. The flux includes inorganic flux, organic flux and resin flux. It can be understood that the melting point of the flux is lower than that of the coating layer 114, and the fluidity of the molten coating layer 114 is increased to form a good alloying between the coating layer 114 and the grid line structures.

In some embodiments, the cross section of the connecting portion 11 is circular, and the circular welding strip does not have orientation and alignment problems, so the circular welding strip is easier to mass produce. In some embodiments, the cross section of the connecting portion 11 may be triangular or any other shape to increase the contact area between the welding strip and the grid line structures and reduce the problem of alignment deviation between the connecting portions 11 and the grid line structures.

In some embodiments, a reflective layer is provided on a surface of the connecting portion 11 away from the solar cell sheet 10, and the reflective layer is located on the outer side of the coating layer 114 away from the solar cell sheet 10 and the body portion 113. The reflective layer is configured to reduce the shielding area of the connecting portion 11 to the solar cell sheet 10. In some embodiments, the outer surface of the coating layer 114 is provided with a reflective groove, which is a recess or a groove recessed in a direction towards the body portion 113 from the coating layer 114. The sunlight is reflected on the solar cell sheet 10 through side walls of the reflective groove, to improve the utilization rate of sunlight.

In some embodiments, the first portion 111 is the part where the connecting portion 11 is alloyed with the grid line structure. The preparation process of the first portion 111 includes: during the lamination process of the coating layer 114, the heat is transferred to the connecting portion 11, so that part of the coating layer 114 on the opposite surface of the solar cell sheet 10 is in the molten state under the melting temperature environment, and the tin element in the coating layer 114 and the silver in the grid linen structure on the solar cell sheet 10 diffuse to form an alloy, and the alloy formed is used as the first portion 111.

In some embodiments, the first portion 111 is a tin layer, and the material of the tin layer is a tin alloy. The tin alloy includes a tin-zinc alloy, a tin-bismuth alloy, or a tin-indium alloy. Tin as welding material has low melting point, good affinity with copper and other metals, and good welding fastness. The use of bismuth can reduce the melting point temperature and surface tension. The melting point of Sn-Bi alloy can be reduced to 139°C to meet the requirements of low-temperature welding. The first portion 111 also has some silver elements in the grid line structure, which enhances the contact between the first portion 111 and the gate line structure. On the one hand, the first portion 111 forms good ohmic contact with the grid line structure with low contact resistance. On the other hand, the welding stress between the first portion 111 and the grid line structure is relatively large, and the welding between the first portion 111 and the grid line structure is relatively firm. The subsequent operation and movement will not cause the separation between the grid line structure and the first portion 111, which is conducive to improving the yield of photovoltaic modules.

In some embodiments, during the formation of the first portion 111, the coating layer 114 wrapped by an isolation layer 121 or the adhesive film cannot be melted, or the melted coating layer 114 will be wrapped by the isolation layer 121, to finally form the second portion 112. The second portion 112 can also be regarded as the coating layer 114 that is not alloyed with the grid line structure. Due to the temperature transfer and the closeness of the isolation layer 121, the thickness of the second portion 112 is thicker as it is farther away from the surface of the solar cell sheet 10. The part of the second portion 112 can be used as a barrier layer with enough thickness to prevent the body portion 113 from piercing the at least one encapsulation layer 12. The at least one encapsulation layer 12 outside the connecting portion 11 can be set thinner to achieve the effect of low weight and reduce the cost. In addition, the second portion 112 is not melted, an area of the multiple connecting portions 11 shielding to the solar cell sheet 10 also decreases accordingly. On the one hand, the thickness of the second portion 112 is thinner than that of the first portion 111 at an initial stage of setting the connecting portion 11, which will reduce the cost. On the other hand, area of the multiple connecting portions 11 shielding to the solar cell sheet is small, which reduces the optical loss of the solar cell sheet 10 and is conducive to improving the cell efficiency 10.

In some embodiments, the outer profile of the second portion away from the body portion being directly opposite to the inner profile of the second portion refer to a distance between any part of the outer profile of the second portion 112 and the midline of the body portion 113 is equal, or the error is less than 10%. The second portion 112 did not melt during the lamination process, that is, the morphology of the second portion 112 before and after the lamination process did not change significantly or did not change.

In some embodiments, the second portion 112 is a tin layer. The compatibility between the tin layer and the body portion 113 is desirable. The tin layer can reduce the transmission loss of the current between the second portion 112 and the body portion 113. In some embodiments, the material of the second portion 112 may be any low-resistance material, and the second portion 112 and the first portion 111 are not converted from the same coating layer 114. The second portion 112 reduces the electrical loss of the connecting portion 11, which is beneficial to improving the cell efficiency.

In some embodiments, the second portion 112 covers the surface of the body portion 113 away from the first portion 111 and the surface of the body portion 113 away from the solar cell sheet 10. In this way, the isolation layer 121 also covers the surface of the body portion 113 away from the first portion 111 and the surface of the body portion 113 away from the solar cell sheet 10. In response to the solar cell sheet 10 being not alloyed with the coating layer 114 to form the first portion 111 and the second portion 112, the isolation layer 121 is configured to prevent the at least one encapsulation layer 12 from entering between the connecting portion 11 and the grid line structure, thereby enabling the insulation between the grid line structure and the connecting portion 11.

In some embodiments, as shown in FIG. 2, the first portion 111 and the second portion 112 are continuous film layers, the coating layer 114 in A custom part area and the coating layer 114 on the surface of the solar cell sheet 10 are the first portion 111, and the remaining coating layer 114 is the second portion 112. In some embodiments, there is a discontinuity between the first portion 111 and the second portion 112, that is, during the welding process of the coating layer 114, part of the coating layer 114 melts to form the first portion 111, part of the coating layer 114 remains to form the second portion 112 due to the effect of the isolation layer 121, and the first portion 111 is disconnected from the second portion 112.

In some embodiments, the area proportion of the second portion 112 is greater than the area proportion of the first portion 111, comparing with the case in which the area proportion of the second portion 112 is smaller than the area proportion of the first portion 111 or the area proportion of the second portion 112 is equal to the area proportion of the first portion 111, a shielding area formed by the alloying of the connecting portion 11 and the grid line structure is smaller, and the electrical loss of the photovoltaic module will also be smaller. The area proportion of the unmelted second portion 112 is greater than that of the melted first portion 111. The temperature during lamination can be set to be smaller, which can avoid the series of problems such as thermal warpage of the solar cell sheet 10 caused by higher temperature.

In some embodiments, the area proportion of the first portion 111 ranges from 1/4 to 2/3 times of the area proportion of the second portion 112 in the cross-section perpendicular to the extension direction of the connecting portion 11. The area proportion of the first portion 111 may range from 1/4 to 1/3 times, 1/4 to 1/2 times, 1/3 to 1/2 times, 1/3 to 4/9 times or 1/2 to 2/3 times of that of the second portion 112. The area proportion of the first portion 111 is 1/4, 0.34, 0.43, 0.58 or 0.64 times that of the second portion 112. In above area proportion relationships between the first portion 111 and the second portion 112, in response to the first portion 111 being larger, the contact area between the connecting portion 11 and the grid line structure is larger, the contact area between the connecting portion 11 and the grid line structure is larger, the contact resistance is lower, and the range of the current collected by the connecting portion 11 is larger, which is conducive to improving the power generation. In response to the first portion 111 being smaller, the shielding area of the connecting portion 11 is small, the electrical loss is small, and the lamination temperature is low, so the thermal stress problem of the solar cell sheet 10 is omittable, which is conducive to improving the yield of the photovoltaic module.

In some embodiments, in some embodiments, the material of the first portion 111 is the same as that of the second portion 112. The first portion 111 and the second portion 112 are converted from the same coating layer 114, which can be used for mass production of connecting portions 11 to improve the preparation efficiency of the photovoltaic module. In response to there being no orientation problem between the first portion 111 and the second portion 112, the connecting portion 11 can be placed on the surface of the solar cell sheet 10 at any angle without alignment problem, which reduces the preparation difficulty of the photovoltaic module.

In some embodiments, the second portion 112 has greater conductivity than that of the body portion 113. The body portion 113 is provided for conductivity, and the second portion 112 is provided as welding solder. The conductivity of the second portion 112 is greater than that of the body portion 113, so that the current transmission path mainly in the body portion 113, which is more conducive to collecting and gathering current.

In some embodiments, referring to FIG. 1 to FIG. 5, the first direction is the transverse direction X, and the first direction intersects with the second direction Y. The grid line structures are the fingers 101, and no corresponding busbar is provided on the surface of the solar cell sheet 10, so as to reduce the shielding area of the busbar, which is conducive to improving the cell efficiency. In some embodiments, the first portion 111 is at least partially located in an overlap between the at least one of the multiple grid line structures and the body portion 113. The overlap here refers to the overlap area between an orthographic projection of the body portion 113 on the solar cell sheet 10 and the multiple grid line structures, or a junction between the body portion 113 and the multiple grid line structures.

In some embodiments, in addition, the transverse direction X and the second direction Y is perpendicular to each other, or there is an included angle less than 90 degrees between the first direction X and the second direction Y, for example, 60 degrees, 45 degrees, 30 degrees, etc., as long as the transverse direction X and the second direction Y are not the same direction. For the convenience of explanation and understanding, the transverse direction X and the second direction Y perpendicular to each other is taken as an example in the embodiments of the present application. In specific applications, the included angle between the transverse direction X and the second direction Y can be adjusted according to the actual needs and application scenarios, which is not limited thereto the embodiments of the present application.

In some embodiments, an orthographic projection of the overlap between the multiple grid line structures and the body section 113 on the solar cell sheet 10 locates in an orthographic projection of the first portion 111 on the solar cell sheet 10, so that the area proportion of first portion 111 in solar cell sheet 10 is larger, the contact area between the first portion 111 and the multiple grid line structures is larger, the welding effect between the solar cell sheet 10 and the connecting portion 11 is better, and the cell efficiency and power generation are desirable.

In some embodiments, as shown in FIG. 1 to FIG. 3, the coating layer 114 of the connecting portion 11 is uniformly covered on the surface of the body portion 113, and the coating layer 114 on the side of the solar cell sheet 10 is in a molten state, and a part of the surface of the first portion 111 in contact with the fingers 101 has silver element. The first portion 111 of the connecting portion 11 is a uniform film layer, which can ensure that the first portion 111 is a continuous and uniform film layer along the first direction, so that the connecting portion 11 can form a good ohmic contact with each of the fingers 101 to avoid false soldering.

In some embodiments, as shown in FIG. 4 to 5, the coating layer 114 of the connecting portion 11 is not a uniform continuous film. The coating layer 114 of the connecting portion 11 only exists on the surface of the body portion 113 corresponding to the multiple fingers 101. The connecting portion 11 includes the body portion 113 and the coating layer 114 spaced along the extension direction of the body portion 113. The coating layer 114 covers the surface of the body portion 113. After lamination, a part of the coating layer 114 melts to form the first portion 111, and the remaining coating layer 114 acts as the second portion 112. This design of the connecting portion 11 reduces the amount of coating layer 114 and the preparation cost of the photovoltaic module. After lamination, a width of the connecting portion 11 in the area without the finger 101 in the second direction is smaller than that of the connecting portion 11 in the area of the multiple fingers 101, which reduces the shielding area of the connecting portion 11, thus improving the cell efficiency.

In some embodiments, referring to FIG. 6 and FIG. 7, the first direction X is parallel to the second direction Y, and each of the multiple connecting portions 11 is in a one-to-one correspondence each of the multiple grid line structures. The multiple grid line structures include the busbars 102, and the fingers 101 provided on the surface of the solar cell sheet 10. The extension direction of the fingers 101 intersects the extension direction of the multiple busbars 102. The multiple main busbars 102 and the multiple fingers 101 are both located on the solar cell sheet 10, and each of the multiple busbars 102 intersects and in electrical contact with at least one of the multiple fingers 101.

In some embodiments, along the first direction X, the first portion 111 is wider than each of the multiple grid line structures. In this way, the first portion 111 completely covers the busbar 102 in a width direction of the busbar 102, that is, the whole of the connecting portion 11 covers the surface of the busbar 102, which maximizes the contact area between the connecting portion 11 and the busbar 102, reduces the contact resistance between the busbar 102 and the connecting portion 11, to reduce the electrical loss.

In some embodiments, the central perpendicular line formed by the busbar 102 along the midpoint of the second direction Y has the same shape with the central perpendicular line formed by the body portion 113 along the midpoint of the second direction Y. Alternatively, as shown in FIG. 7, the central perpendicular line 115 of the cross section of the body portion 113 along the second direction Y overlaps with the central perpendicular line 105 of the cross section of the busbar 102 along the second direction Y. The connecting portion 11 is fully aligned with the busbar 102, and the connecting portion 11 can form a good contact with the busbar 102, to avoid false soldering and miss soldering. In some embodiments, there is a deviation of less than 20% between the central perpendicular line 115 of the cross section of the body portion 113 along the second direction Y and the central perpendicular line 105 of the cross section of the busbar 102 along the second direction Y.

In some embodiments, referring to FIG. 8 to FIG. 10, the photovoltaic module further includes multiple connecting layers 104 spaced along the extension direction of the connecting portion 11, and each of the multiple connecting layers 104 is located between the solar cell sheet 10 and each of the multiple connecting portions 11. The connecting layer 104 is positioning glue, which positions the connecting portion 11 by glue points, accurately determines the position relationship between the connecting portion 11 and the grid line structure, to form desirable contact between the connecting portion 11 and the solar cell sheet during the subsequent welding or lamination treatment, thus maximizing the cell efficiency. In addition, the length of the grid line structure between the adjacent connecting portions 11 is enabled to be similar by the positioning glue, so that the transmission path of the current collected by the solar cell sheet 10 is more uniform, thereby reducing the transmission loss.

In some embodiments, referring to FIG. 10, since the connecting layer 104 wraps the coating layer 114, the coating layer 114 partially located in the connecting layer 104 acts as the third portion 116. For the same connecting portion 11, the area proportion of the third portion 116 is smaller than that of the first portion 111. In response to the area proportion of the third portion 116 being large, the thickness of the connecting layer 104 is relatively thick, and the thickness of the connecting layer 104 makes the connecting portion 11 not offset in the operation before lamination. In response to the area proportion of the third portion 116 being small, the area proportion of the first portion 111 is also small, so that the diffusion area and shielding area of the connecting portion 11 are small, thereby reducing the electrical loss.

In some embodiments, the at least one encapsulation layer 12 includes a first encapsulation layer and a second encapsulation layer. The first encapsulation layer is configured to cover one of a front surface and a rear surface of the solar cell sheet, and the second encapsulation layer is configured to cover the other of the front surface and the rear surface of the solar cell sheet. Specifically, at least one of the first encapsulation layer and the second encapsulation layer is an ethylene-vinyl acetate (EVA) copolymer adhesive film, polyethylene octene co-elastomer (POE) film or polyvinyl butyraldehyde (PVB) film and other organic package films.

In some embodiments, the at least one cover plate 13 is embodied as a glass cover plate, a plastic cover plate and other cover plates with light transmission function. Specifically, the surface of the at least one cover plate 13 towards the at least one encapsulation layer 12 has recesses and protrusions, thus increasing the utilization of incident light. The at least one cover plate 13 includes a first cover plate and a second cover plate. The first cover plate is opposite to the first encapsulation layer, and the second cover plate is opposite to the second encapsulation layer.

The photovoltaic module is provided according to the embodiments of the present application, where a surface of the solar cell sheet 10 is provided with multiple grid line structures spaced along the first direction X, each of the multiple connecting portions 11 is in electrical contact with at least one of the multiple grid line structures, and each of the multiple connecting portions 11 includes a body portion 113, a first portion 111 and a second portion 112 disposed on a surface of the body portion 113. For the same connecting portion 11, the area proportion of the first portion 111 is less than the area proportion of the second portion 112 in the cross-section perpendicular to the extension direction of the connecting portion 11. It can be naturally deduced that the connection between the connecting portion 11 and the solar cell sheet 10 is not achieved by heating a top portion of the connecting portion 11 in a direction towards the solar cell sheet 10, which can avoid the damage, crack and excessive thermal stress of the solar cell sheet 10 caused by the good ohmic contact between the connecting portion 11 and the solar cell sheet 10. The second portion 112 is not on the surface of the solar cell sheet 10, so that the connecting portion 11 and the grid line structure can be alloyed by low temperature lamination. A part of the second portion 112 is not melted, and the part of the second portion 112 can be used as a barrier layer with enough thickness configured to prevent the body portion 113 from piercing the at least one encapsulation layer 12. The at least one encapsulation layer 12 outside the multiple connecting portions 11 can be set thinner to achieve low weight of adhesive film and reduce cost. In addition, in response to the second portion 112 being not melt, an area of the multiple connecting portions 11 shielding the solar cell sheet 10 also decreases accordingly. On the one hand, the thickness of the second portion 112 is thinner than that of the first portion 111 at an initial stage of setting the connecting portion 11, which will reduce the cost. On the other hand, area of the multiple connecting portions 11 shielding the solar cell sheet is small, which reduces the optical loss of the solar cell sheet 10 and is conducive to improving the cell efficiency.

Accordingly, on the other aspect, a method for preparing a photovoltaic module is provided according to the embodiments of the present application, the method is used to prepare the photovoltaic module according to the above embodiments. The same or similar components as the above embodiment are not described here.

Referring to FIG. 16, a solar cell sheet 10 is provided, and multiple grid line structures spaced along the first direction X are provided on a surface of the solar cell sheet 10. The multiple grid line structures shown in FIG. 12 are the fingers 101. In some embodiments, multiple fingers 101 extending in the second direction Y and multiple busbars 102 extending in the first direction X are provided on the surface of the solar cell sheet 10.

Referring to FIG. 10, the multiple connecting layers 104 are arranged on the surface of the solar cell sheet 10 in a spaced manner. Each of the connecting layers 104 is located between the adjacent fingers 101. The multiple connecting layers 104 are arranged along the second direction Y in a spaced manner. Alternatively, the multiple connecting layers 104 may be staggered along the second direction Y, that is, a first connecting layer 104 is arranged between a first finger 101 and a second finger 101, a second connecting layer 104 is arranged between the second finger 101 and a third finger 101, a third connecting layer 104 is arranged between the first finger 101 and the second finger 101, and so on.

In some embodiments, referring to FIG. 16, the connecting portion 11 shown in FIG. 11 to FIG. 15 is laid on the surface of the solar cell sheet 10 to fix the area with the connecting layer 104 in ultraviolet light to enhance the adhesion of the connecting layer 104. The insulating layer 121 is covered on the surface of the connecting portion 11. The length of the insulating layer 121 along the second direction Y is greater than 2/3 of the outer circumference of the coating layer 114 to form a relatively complete wrapping. Further, the length of the isolation layer 121 is greater than the outer circumference of the coating layer 114, and both ends of the isolation layer 121 are located on the surface of the solar cell sheet 10. It can be understood that since the isolation layer 121 has a certain toughness and the effect of gravity, a certain number of pores are formed between the isolation layer 121, the solar cell sheet 10 and the connecting portion 11, that is, a part of the coating layer 114 is not completely wrapped by the isolation layer 121. The part of the coating layer 114 that is not wrapped is converted into the first portion 111 in the subsequent lamination, and the coating layer 114 that is wrapped by the isolation layer 121 is converted into the second portion 112.

In some embodiments, the material of the isolation layer 121 is the same as that of the at least one encapsulation layer 12, and the isolation layer 121 is attached to the adhesive film in the subsequent lamination process. As a part of the at least one encapsulation layer 12, the isolation layer 121 is compatible with the film layer, so that the at least one encapsulation layer 12 can better protect the solar cell sheet 10 from the erosion of moisture and the risk of damage of the solar cell sheet 10 due to the internal gap. The isolation layer 121 is a pre-crosslinked adhesive film with a pre-crosslinked degree of 50% to 70%. By setting the pre-crosslinked degree within the above range, the isolation layer 121 can fix the connecting portion 11 before the lamination treatment to prevent the connecting portion 11 from moving. The isolation layer is further configured to avoid the crack or faulty soldering of the solar cell sheet due to displacement of the welding strip, which is caused by the pushing of the molten adhesive film or the overflow of the adhesive film between the welding strip and the finger 101 during the welding process between the connecting portion 11 and the finger 101. In addition, in response to the pre-crosslinked degree being greater than 85%, since the subsequent cross-linking reaction on the at least one encapsulation layer 12 will increase the adhesion, and cross-linking reaction will be carried out on the isolation layer 121, the cross-linking degree of the isolation layer 121 is greater, and the hardness of the isolation layer 121 is greater, so that there is a gap between the isolation layer 121, the solar cell sheet 10 and the connecting portion 11, or the isolation layer 121 with greater hardness will damage the surface of the solar cell sheet 10, which will affect the cell performance.

In some embodiments, referring to FIG. 17, the adhesive film 122 is provided. The adhesive film 122 is laid on the surface of the solar cell sheet 10 and covers the surface of the solar cell sheet 10, the connecting portion 11 and the isolation layer 121. The at least one cover plate 13 is provided, which is located on the surface of the adhesive film 122 away from the solar cell sheet 10. Lamination process is performed, the coating 114 is converted into the first portion 111 and second portion 112, or the first portion 111, the second portion 112 and the third portion 116. The adhesive film 122 is bonded with the isolation layer 121 to form the at least one encapsulation layer 12.

In some embodiments, the isolation layer 121 is not provided, and the adhesive film 122 is directly laid on the surface of the connecting portion 11 and the solar cell sheet 10. A part of the coating layer 114 covered by the adhesive film 122 is used as the second portion 112, and a part of the coating layer 114 alloyed with the grid line structure is used as the first portion 111.

In some embodiments, referring to FIG. 18, in response to the material of the isolation layer 121 being not the same as the material of the adhesive film 122, the adhesive film 122 is converted into the at least one encapsulation layer 12, and the isolation layer 121 is still located between the at least one encapsulation layer 12 and the solar cell sheet 10, and between the at least one encapsulation layer 12 and the connecting portion 11. The melting point of the isolation layer 121 is greater than that of the laminator and the adhesive film 122 during the lamination process, so as to prevent the molten adhesive film 122 from immersing between the connecting portions 11 and the grid line structure, resulting in affecting the welding effect of the solar cell sheet 10 and the connecting portions 11.

Although the present application is disclosed above with preferred embodiments, it is not used to limit the claims. The scope of protection shall be subject to the scope defined by the claims of the present application. In addition, the embodiments and the accompanying drawings in the specification of the present application are only illustrative examples, which will not limit the scope protected by the claims of the present application.

Those of ordinary skill in the art can understand that the above embodiments are specific examples for realizing the present application, and in actual disclosures, various changes may be made in shape and details without departing from the spirit and range of the present application. Therefore, the protection scope of the present application should be subject to the scope defined by the claims.

## Claims

1. A photovoltaic module, comprising:
a solar cell sheet having a surface of the solar cell sheet and a plurality of grid line structures provided on the surface and spaced along a first direction;
a plurality of connecting portions arranged over the surface of the solar cell sheet and spaced along a second direction distinct from the first direction, wherein each of the plurality of connecting portions is in electrical contact with at least one of the plurality of grid line structures, each of the plurality of connecting portions comprises a first portion on the surface of the solar cell sheet, a body portion on the first portion, and a second portion disposed on a surface of the body portion, the first portion is alloyed with the at least one of the plurality of grid line structures, an outer profile of the second portion away from the body portion has a same shape with an inner profile of the second portion, and, for each connecting portion in the plurality of connecting portions, an area proportion of the first portion is less than an area proportion of the second portion in a cross section perpendicular to an extension direction of the plurality of connecting portions;
at least one encapsulation layer disposed over the surface of the solar cell sheet and encapsulating the plurality of grid line structures and the plurality of connecting portions; and
at least one cover plate disposed on a side of the at least one encapsulation layer away from the surface of the solar cell sheet.

2. The photovoltaic module according to claim 1, wherein the area proportion of the first portion ranges from 1/4 to 2/3 times of the area proportion of the second portion in the cross-section perpendicular to the extension direction of the connecting portion.

3. The photovoltaic module according to claim 1, wherein the plurality of grid line structures include a plurality of fingers.

4. The photovoltaic module according to claim 1, wherein each of the plurality of connecting portions further includes a coating layer covering the surface of the body portion, and the coating layer is configured to subsequently form the first portion and the second portion.

5. The photovoltaic module according to claim 4, wherein before lamination, the coating layer is uniformly covered on the surface of the body portion, and a width of the coating layer along the extension direction of the plurality of connecting portions is greater than or equal to a width of the plurality of fingers.

6. The photovoltaic module according to claim 4, wherein before lamination, the coating layer is not uniformly coated on the surface of the body portion, a part of the coating layer with a thicker circumference is processed to be the first portion, and the other part of the coating layer with a thinner circumference is processed to be the second portion.

7. The photovoltaic module according to claim 1, wherein the first direction intersects with the second direction, and the first portion is at least partially located in an overlap between the at least one of the plurality of grid line structures and the body portion.

8. The photovoltaic module according to claim 7, wherein an orthographic projection of the overlap between the at least one of the plurality of grid line structures and the body portion on the solar cell sheet is located in an orthographic projection of the first portion on the solar cell sheet.

9. The photovoltaic module according to claim 1, wherein the first direction is parallel to the second direction, and each of the plurality of connecting portions is in a one-to-one correspondence each of the plurality of grid line structures.

10. The photovoltaic module according to claim 9, wherein the first portion is wider than each of the plurality of grid line structures along the first direction.

11. The photovoltaic module according to claim 1, wherein the second portion is configured to cover a surface of the body portion away from the first portion and the solar cell sheet.

12. The photovoltaic module according to claim 1, wherein material of the first portion is the same as material of the second portion.

13. The photovoltaic module according to claim 12, wherein the second portion has greater conductivity than the body portion.

14. The photovoltaic module according to claim 1 or 12, wherein at least one of the first portion and the second portion is a layer made of tin (Sn), and the body portion is a copper layer.

15. The photovoltaic module according to claim 1, further comprising: a plurality of connecting layers spaced along the extension direction of the connecting portion, and each of the plurality of connecting layers is located between the solar cell sheet and each of the plurality of connecting portions.
